(19) Europäisches Patentamt / European Patent Office / Office européen des brevets

(11) **EP 4 004 354 B1**

(12) **FASCICULE DE BREVET EUROPEEN**

(45) Date de publication et mention
de la délivrance du brevet:
**22.01.2025 Bulletin 2025/04**

(21) Numéro de dépôt: **20820478.4**

(22) Date de dépôt: **31.07.2020**

(51) Classification Internationale des Brevets (IPC):
*F02C 7/232* (2006.01)   *G01R 31/00* (2006.01)
*G01R 31/72* (2020.01)   *H01F 7/18* (2006.01)

(52) Classification Coopérative des Brevets (CPC):
**G01R 31/008; F02C 7/232; G01R 31/72;**
H01F 7/1844; H01F 2007/1855

(86) Numéro de dépôt international:
**PCT/FR2020/051412**

(87) Numéro de publication internationale:
**WO 2021/019190 (04.02.2021 Gazette 2021/05)**

(54) **DÉTECTION AUTOMATIQUE D'UNE CONFIGURATION HARDWARE D'UN ÉQUIPEMENT EMBARQUÉ DANS UN AÉRONEF**

AUTOMATISCHE ERKENNUNG EINER HARDWARE-KONFIGURATION EINES GERÄTES AN BORD EINES FLUGZEUGS

AUTOMATIC DETECTION OF A HARDWARE CONFIGURATION OF A PIECE OF EQUIPMENT LOCATED ON-BOARD AN AIRCRAFT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2019 FR 1908730**

(43) Date de publication de la demande:
**01.06.2022 Bulletin 2022/22**

(73) Titulaire: **SAFRAN AIRCRAFT ENGINES**
**75015 Paris (FR)**

(72) Inventeurs:
• **GAUVRIT, Jacques Paul Michel**
**77550 Moissy-Cramayel (FR)**
• **MASSON, Davy Philippe**
**77550 Moissy-Cramayel (FR)**

(74) Mandataire: **Ernest Gutmann - Yves Plasseraud S.A.S.**
**C/o Plasseraud IP**
**104 Rue de Richelieu**
**CS 92104**
**75080 Paris Cedex 02 (FR)**

(56) Documents cités:
**US-A- 5 490 031        US-A1- 2004 181 760**
**US-A1- 2009 052 107        US-A1- 2017 356 948**

## Description

Domaine technique de l'invention

La présente invention porte sur les équipements embarqués d'un aéronef, en particulier les équipements de régulation de carburant en particulier pour une turbomachine tel qu'un turboréacteur ou un turbopropulseur.

Etat de la technique antérieure

Il existe plusieurs calculateurs embarqués dans les aéronefs visant à la supervision des différents équipements embarqués, afin d'en assurer leur bon fonctionnement. En particulier, les équipements dont le dysfonctionnement est critique nécessitent une supervision par deux calculateurs, l'un des calculateurs étant dédié à la redondance et utilisé en cas de dysfonctionnement de l'autre des calculateurs. Les deux calculateurs forment en général deux voies d'une unité de commande connue sous l'acronyme anglais EPMU pour *Electronic and protection monitor unit.*

Ces calculateurs sont également appelés calculateurs de protection. Une de leur mission est d'empêcher l'acheminement de carburant vers la turbomachine lorsqu'un dysfonctionnement est identifié pour éviter tout évènement catastrophique.

D'un modèle de turbomachine à l'autre, selon leur architecture, les calculateurs de protection peuvent être amenés à commander des équipements de dosage et régulation de carburant (en anglais FMU pour *Fuel Metering Unit)*. Par exemple, lorsqu'une survitesse de la turbomachine est détectée, l'EPMU envoie une commande aux FMU pour contrôler et/ou réduire le fuel injecté.

Il existe différents modèles d'équipements de régulation, présentant des caractéristiques matérielles différentes, et donc en particulier nécessitant des courants de commande d'intensités variables.

Egalement, il est possible lors des opérations de maintenance de remplacer un premier modèle de FMU par un deuxième modèle de FMU. L'envoi d'un courant de commande d'intensité trop élevé pourrait endommager l'équipement et l'envoi d'un courant de commande trop faible peut impacter la protection de la turbomachine en cas de dysfonctionnement.

Aujourd'hui, les informations relatives à l'architecture de la turbomachine, c'est-à-dire le nombre, le positionnement ainsi que le modèle de FMU utilisé est renseigné dans le logiciel applicatif de protection exécuté par les calculateurs de protection.

Ainsi une modification du modèle de FMU, lors d'une opération de maintenance, nécessite une modification du logiciel applicatif de protection pour éviter tout problème de fonctionnement.

L'invention a notamment pour but d'apporter une solution simple, efficace et économique aux inconvénients de la technique actuelle exposée ci-dessus.

On connait les documents US2017/356948, US2009/052107 et US5490031. L'invention a notamment pour but d'apporter une solution simple, efficace et économique aux inconvénients de la technique actuelle exposée ci-dessus.

Résumé de l'invention

A cette fin, il est proposé un procédé de détection d'une configuration matérielle d'un équipement embarqué dans un aéronef tel que défini dans la revendication indépendante 1.

La déduction de la configuration matérielle de l'équipement peut être réalisée à partir desdites une ou plusieurs valeurs du courant $I$ mesuré et des caractéristiques électriques de réponse en courant de l'équipement.

Lorsque l'équipement est, par exemple, un FMU, un tel procédé, implémenté sur un calculateur de protection permet, lors d'une phase de mise sous tension des équipements, c'est-à-dire au démarrage de ces derniers, de détecter automatiquement le modèle de FMU relié aux calculateurs de protection, et donc d'adapter le courant de contrôle à chaque modèle de FMU.

Ainsi en s'appuyant sur les caractéristiques électriques des modèles de FMU, il est possible d'en déduire leurs modèles. Pour cela, la réponse en courant à un courant de commande est analysée de sorte à déduire automatiquement, c'est-à-dire sans intervention humaine, la configuration matérielle de chacun des équipements. Par analysé, on entend que la valeur du courant en sortie de l'équipement en réponse au courant de commande, ainsi que la variation temporelle du courant en sortie sont analysées.

Ainsi, en faisant un test discriminant de la configuration, la solution assure le pilotage d'équipement de configuration matérielle hétérogène, tout en garantissant la fonction de protection contre les dysfonctionnements inopinés de la turbomachine (en anglais *Hazardous Engine Effects)*.

L'invention est applicable pour tout équipement comprenant un actionneur électrique comportant un bobinage, et donc présentant une inductance. Par exemple, dans le cas d'un FMU, l'invention est applicable grâce à la présence d'une servovalve électrohydraulique (EHSV) permettant la commande de la vanne de dosage de carburant (FMV).

Additionnement, la configuration matérielle d'un équipement peut être au moins l'une des configurations suivantes :

- un premier équipement ayant une première inductance $L_1$;
- un deuxième équipement ayant une seconde inductance $L_2$;
- un équipement de configuration matérielle inconnue,

et dans lequel $L_2 = x \cdot L_1$ où $x \in \mathbb{R}$ et $x \geq 10$.

Ainsi, l'équipement avec une inductance L1 comprise entre 50 mH et 150mH est considéré comme un équipement avec une faible inductance. L'équipement avec une inductance L2 comprise entre 0,9 H et 1,5 H, est considéré comme un équipement à forte inductance.

L'étape c) peut consister à comparer les une ou plusieurs valeurs du courant de réponse I mesuré à un premier seuil $I_{min1,FMU1}$ et à un second seuil $I_{max2,FMU2}$ inférieur au premier seuil, de sorte que :

- un premier équipement est détecté, si les valeurs du courant mesuré I sont supérieures au premier seuil $I_{min1,FMU1}$,
- un second équipement est détecté, si les valeurs du courant mesuré I sont inférieures au second seuil, $I_{max2,FMU2}$,
- un équipement de configuration matérielle inconnue est détecté si les valeurs du courant mesuré I sont comprises entre le second seuil et le premier seuil.

Par conséquent, en faisant une acquisition du courant pendant, le procédé compare la valeur du courant mesuré à la valeur minimale de courant en sortie du premier équipement et à la valeur maximale de courant en sortie du deuxième équipement, au même instant t, en réponse au même courant de commande.

De plus, le procédé peut en outre comprendre une étape consistant à :

- mesurer une ou plusieurs valeurs du courant de réponse I à au moins un instant $t_3$ postérieur à une valeur de borne supérieure $t_2$, de l'intervalle de temps de mesure, et
- déduire que la configuration matérielle est celle d'un premier équipement défectueux ou celle d'un second équipement défectueux si les valeurs du courant de réponse mesuré *I sont inférieures à un troisième seuil ($I_{min\,3}$)*.

Un troisième seuil permet ainsi de d'identifier en outre un premier ou second équipement défectueux.

Les configurations matérielles des premier et second équipements peuvent avoir une même valeur de résistance.

De préférence, la première inductance $L_1$ peut être de l'ordre de 100 *mH* et la seconde inductance $L_2$ peut être de l'ordre de 1*H.*

En outre, le courant de réponse de l'équipement peut s'exprimer :

$$ I = Ic \left( 1 - e^{-\frac{t}{\sigma}} \right) avec\ \sigma = \frac{L}{R} $$

dans lequel, L est l'impédance de l'équipement et R est la résistance de l'équipement.

En fonction de la valeur du courant mesuré en sortie de l'équipement, en connaissance de la résistance de cet équipement quelle qu'en soit sa structure, il est possible de déterminer la configuration matérielle de l'équipement, et ceci de manière automatique.

En d'autres termes, le temps de réponse de l'équipement à un courant de commande envoyée par le calculateur, permet à celui-ci, d'identifier, pour chacun équipement, sa configuration matérielle de manière automatique, lors de leur démarrage. Ainsi, le calculateur de protection peut ensuite adapter les niveaux de ces courants de commande pour chacun des équipements en fonction de sa configuration matérielle c'est-à-dire de son modèle.

Egalement, le courant de consigne peut être envoyé par un calculateur de protection embarqué de l'aéronef. Le courant de consigne *Ic* peut être de l'ordre de 400 mA.

En fonction des valeurs des courants mesurés $I_1$, $I_2$ aux instants $t_1$ et $t_2$, il est possible de caractériser la réponse de l'équipement au courant de commande, en particulier son temps de réponse. La mesure de la valeur du courant à deux instants $t_1$ et $t_2$ permet d'assurer une certaine robustesse du procédé au regard des variabilités environnementales pouvant impacter le temps de réponse de l'équipement.

En particulier, les étapes a) à c) peuvent être réalisées lors d'une mise sous tension de l'équipement.

En outre, l'équipement peut comprendre un actionneur d'un organe mobile d'un appareil de dosage de carburant, ledit actionneur comprenant au moins une bobine électrique fixe et un noyau mobile. En effet, il existe aujourd'hui au moins deux types d'organe de dosage de carburant possédant des configurations matérielles différentes, qui comme détaillé plus haut, se caractérise par une faible impédance ou une forte impédance. En effet, les servovalves électrohydrauliques (EHSV) permettant la commande de la vanne de dosage de carburant (FMV) utilisés dans les deux modèles de FMU, présentent des impédances différentes. Grâce à l'invention, lors des opérations de maintenance, un premier type d'organe de dosage de carburant peut être substitué par un deuxième type d'organe de dosage de carburant, ceci sans risque qu'un courant de commande avec un niveau inadapté ne lui soit envoyé. L'adaptation du niveau de courant envoyé par le ou les calculateurs de protection se fait alors automatiquement.

Le présent document porte aussi sur un calculateur de protection comprenant un processeur couplé à une mémoire tel que le programme précité est enregistré sur la mémoire. Egalement, le présent document porte sur un calculateur de protection comprenant un processeur couplé à une mémoire sur laquelle sont enregistrées des instructions pour mettre en oeuvre le procédé tel que précité lorsqu'exécuté sur l'ordinateur.

Brève description des figures

[Fig. 1] représente l'évolution temporelle des courants maximum et minimum en sortie d'un premier et deuxième modèle d'organe de dosage de carburant en réponse à un courant de commande de l'ordre de 400 mA ;

[Fig. 2] est un logigramme du procédé de détection d'une configuration matérielle d'un équipement embarqué dans un aéronef selon un premier mode de réalisation ;

[Fig. 3] schématise les mesures réalisées dans le cadre du procédé selon un premier mode de réalisation ;

[Fig. 4A] est une courbe représentant les courants de sortie maximum et minimum d'un organe de dosage de carburant d'un premier modèle en réponse à un courant de consigne ;

[Fig. 4B] est une courbe représentant les courants de sortie du premier modèle lorsqu'un court-circuit a lieu sur l'une des voies de l'unité de commande ;

[Fig. 5A] est une courbe représentant les courants de sortie maximum et minimum d'un organe de dosage de carburant d'un deuxième modèle en réponse à un courant de consigne ;

[Fig. 5B] est une courbe représentant les courants de sortie du deuxième modèle lorsqu'un court-circuit a lieu sur l'une des voies de l'unité de commande ;

Description détaillée de l'invention

Lors d'opérations de maintenance, le remplacement d'une unité de dosage de carburant (connue sous l'acronyme anglais FMU pour Fuel Metering Unit) n'implique pas nécessairement un remplacement à l'identique, de sorte qu'un organe de dosage de carburant avec une première configuration matérielle peut être remplacé par un organe de dosage avec une deuxième configuration matérielle différente de la première configuration matérielle.

Deux modèles d'organe de dosage sont aujourd'hui utilisés, et présente chacun une configuration matérielle propre.

Le premier modèle, connu sous l'appellation FMU Cutback, présente une première inductance L1, de l'ordre de 100 *mH.* De manière générale, la première inductance de ce premier modèle est comprise entre 0 mH et 150mH.

Le deuxième modèle, connu sous l'appellation FMU Baseline, présente une deuxième inductance L2, de l'ordre de 1 *H.* De manière générale, la deuxième inductance de ce deuxième modèle est comprise entre 0,9 H et 1,5 H.

Ces deux configurations matérielles présentent une même résistance. Néanmoins, la résistance de ces FMU est fortement dépendante de la température subie par le FMU. Par conséquent, la résistance de ces équipements présente une forte variabilité en fonction de la tolérance de la résistance ainsi que de la température de l'environnement dans lequel sont intégrés les FMU.

Ainsi, de manière générale, on qualifie les inductances L1 et L2 respectivement de faible et de forte inductances, ces inductances pouvant s'exprimer $L_2 = x \cdot L_1$ où $x \in \mathbb{R}$ et $x \geq 10$.

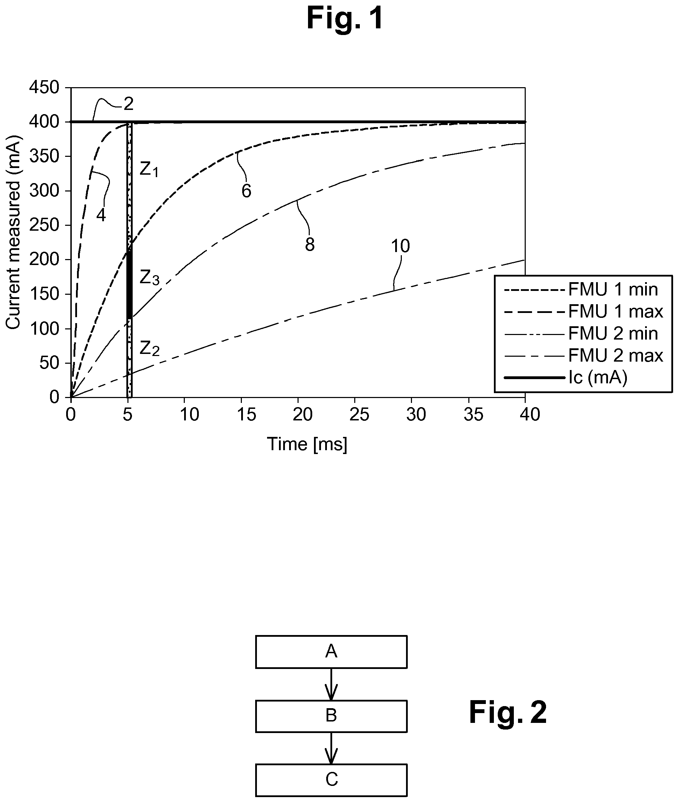

La figure 1, illustre la réponse en courant du premier modèle FMU1 et du deuxième modèle FMU2 à un courant de consigne 2 de l'ordre de 400 mA.

La réponse en courant du premier modèle FMU1 à ce courant de consigne est comprise entre une courbe du courant maximum de sortie 4 et une courbe du courant minimum de sortie 6. Cette variation de courant de sortie dépend de la température à laquelle est soumis l'organe de dosage de carburant.

Similairement, la réponse en courant du deuxième modèle FMU2 à ce courant de consigne est comprise entre une courbe du courant maximum de sortie 8 et une courbe du courant minimum de sortie 10.

De manière générale, le courant en sortie de l'équipement s'exprime :

$$I = Ic \left( 1 - e^{-\frac{t}{\sigma}} \right) avec \ \sigma = \frac{L}{R}$$

dans lequel, L est l'impédance de l'équipement et R est la résistance de l'équipement, la résistance étant variable en fonction de la température à laquelle est soumis le FMU.

Ainsi, deux zones Z1 et Z2 sont délimitées, la première zone Z1 représentant l'ensemble des valeurs pouvant être prises par les courants de sortie du premier modèle FMU1 et la deuxième zone Z2 représentant l'ensemble des valeurs pouvant être prises par les courants de sortie du deuxième modèle FMU2. Comme cela est visible sur la figure 1, ces zones Z1, Z2 ne se recouvrent pas. Le procédé de détection selon l'invention s'appuie sur ce dernier point pour permettre une détection automatique du modèle d'organe de dosage de carburant utilisé.

La figure 2 illustre un mode de réalisation d'un procédé de détection d'une configuration matérielle d'un équipement embarqué, ici un organe de dosage de carburant, dans un aéronef. Comme détaillé en référence à la figure 1, les deux modèles FMU1 et FMU 2 d'organe de dosage de carburant sont aptes à recevoir en entrée un courant de consigne *Ic*, et, en réponse à ce courant de consigne, à produire en sortie un courant *I*.

L'organe de dosage est embarqué dans un environnement, où il est supervisé par une unité de commande, EPMU, à deux voies, c'est-à-dire avec deux calculateurs pour la redondance de la protection. Ces deux calculateurs, par exemple constitués par deux cartes électroniques dans un même boîtier, sont reliés à un même FMU, de sorte qu'en cas de dysfonctionnement de

**EP 4 004 354 B1**

l'un, le pilotage de l'organe de dosage de carburant soit assuré par le calculateur sain restant. La première étape A du procédé consiste à envoyer en entrée de l'équipement un courant de consigne $Ic$ à un instant donné $t_0$.

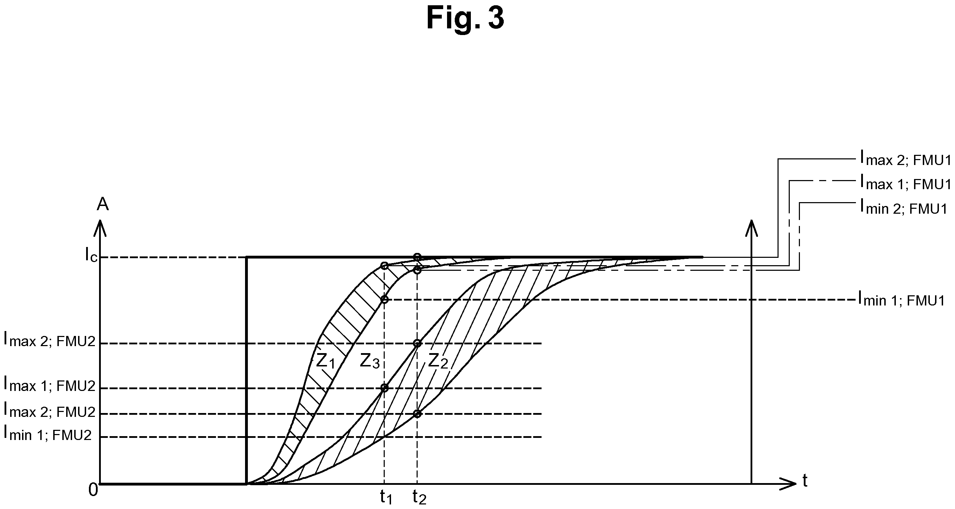

Comme on peut le voir dans l'exemple de la figure 3, le courant de consigne $Ic$ est un courant continu, émis à partir de $t_0 = 0$ *ms.*

La deuxième étape B dudit procédé consiste à mesurer les valeurs du courant $I_1$ et $I_2$ en sortie de l'équipement respectivement à des instants $t_1$ et $t_2$ postérieurs à $t_0$.

Lors de cette deuxième étape, par exemple deux mesures de la réponse en courant (non représenté sur la figure 3) en sortie de l'organe de courant, sont réalisées à deux instants $t_1$ et $t_2$ postérieurs à $t_0$.

Les instants $t_1$ et $t_2$ sont choisis par exemple aux alentours de 5 ms, de façon à définir un intervalle de temps de mesure par exemple inférieur à 1 ms comme illustré schématiquement sur la figure 1.

Comme cela est schématisé, en fonction des valeurs de courant mesurées dans l'intervalle de temps de mesure entre $t_1$ et $t_2$, il possible de déduire lors qu'une troisième étape C la configuration matérielle de l'organe de dosage de carburant.

Par exemple, en mesurant un courant de réponse $I_1$ à l'instant $t_1$ et $I_2$ à l'instant $t_2$ , la déduction s'appuie sur la comparaison des valeurs $I_1$, $I_2$ avec les plages suivantes :

- comparaison de $I_1$ à l'instant $t_1$ et de $I_2$ à l'instant $t_2$ :

  - si $I_1 \in [I_{min\ 1\ ;FMU1}; I_{max\ 1\ ;FMU1}]$ et $I_2 \in [I_{min\ 2\ ;FMU1}; I_{max\ 2\ ;FMU1}]$, c'est-à-dire à la zone Z1, alors l'organe de dosage de carburant présente la configuration matérielle du premier modèle FMU1 ;
  - si $I_1 \in [I_{min\ 1\ ;FMU2}; I_{max\ 1\ ;FMU2}]$ et $I_2 \in [I_{min\ 2\ ;FMU2}; I_{max\ 2\ ;FMU2}]$, c'est-à-dire à la zone Z2, alors l'organe de dosage de carburant présente la configuration matérielle du deuxième modèle FMU2.

Cette comparaison permet en d'autres termes de caractériser le temps de réponse de l'organe de dosage de carburant et de le comparer avec le temps de réponse connu des premier et deuxième modèles.

Comme on peut le voir, si $I_1 \in [I_{max\ 1\ ;FMU2}; I_{min1\ ;FMU1}]$ et $I_2 \in [I_{max\ 2\ ;FMU2}; I_{min\ 2\ ;FMU1}]$, c'est à dire à la zone Z3, alors il est impossible de déterminer la configuration matérielle de l'organe de dosage de carburant. Lorsque le procédé est mis en oeuvre sur le calculateur, un message d'erreur est alors retourné.

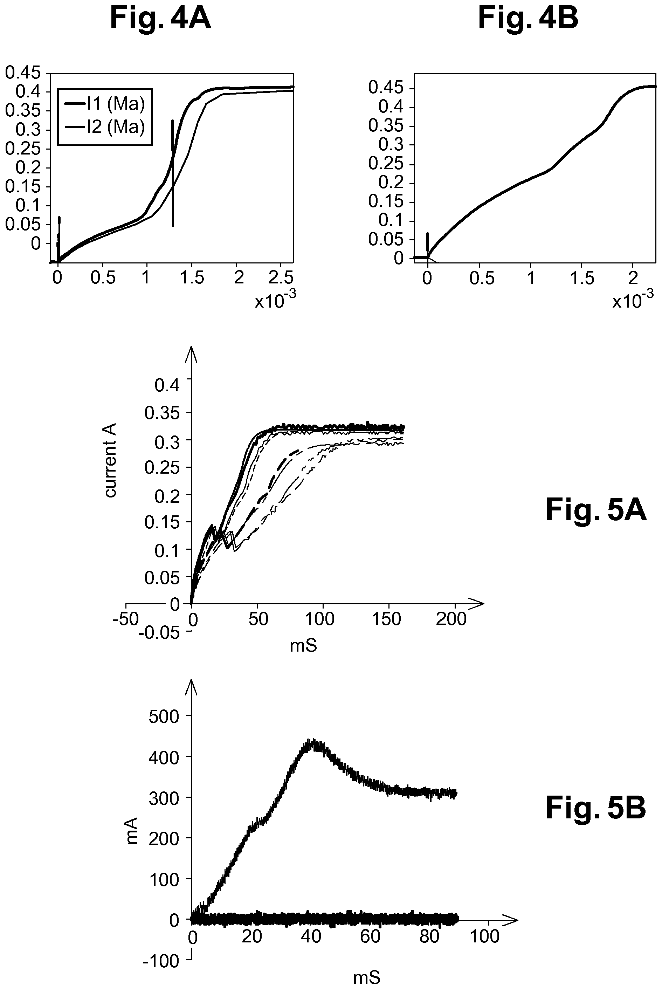

Bien-sûr, il possible de limiter le procédé à la mesure d'une seule valeur du courant de sortie à un instant t, compris dans l'intervalle de temps de mesure entre $t_1$ et $t_2$, et déduire la configuration matérielle de l'équipement, en fonction de la valeur du courant mesuré $I$. C'est-à-dire, en d'autres termes, d'identifier dans quelle zone Z1 ou Z2 le courant I mesuré se situe. Une troisième mesure à l'instant $t_3$ peut se révéler utile notamment lorsqu'un court-circuit a lieu sur l'une des voies de l'unité de commande EPMU. Cet instant $t_3$ identifié sur la figure 3 est postérieur à l'instant $t_2$, permet notamment d'identifier des courants inférieurs au courants de sortie de la zone Z2, dans la zone Z4 qui correspondent alors à des premiers ou seconds équipements avec des défauts matériels. Dans ce cas, comme on peut le voir sur les figures 4B et 5B, les courants en sortie de l'organe de dosage de carburant s'en retrouve impacté en réponse à un courant de commande de l'ordre de 400 mA. En comparant donc la valeur de courant de sortie à l'instant $t_3$ à un troisième seuil $I_{min\ 3}$, il possible de détecter un équipement défectueux.

Un exemple de défaut de l'équipement est une dérive de l'actionneur impliquant que son temps de réponse sort d'un gabarit prédéfini lorsqu'il est soumis à une sollicitation en courant. Un autre exemple de défaut peut être un court-circuit d'une bobine d'un actionneur à deux bobines.

Néanmoins, comme dans les cas décrit précédemment, l'évolution du courant de sortie de l'organe de carburant reste similaire au cas sans court-circuit.

En effet, comme on peut le voir sur la figure 4A, en réponse à un courant de consigne par exemple voisin de 400 mA, le courant de sortie du premier modèle FMU1 atteint 400 mA entre 1,5 ms et 2ms (selon la température de l'environnement de l'organe de dosage de carburant), en considérant que le courant de consigne soit émis à partir de $t = 0$ *ms.* En cas de court-circuit la valeur de 400 mA est atteinte à 2ms comme cela est visible à la figure 4B. Ainsi, malgré un court-circuit sur l'une des voies de l'unité de commande, le test de la valeur du courant de sortie reste discriminant.

Cela est également confirmé pour la deuxième configuration matérielle. En effet, comme cela est visible sur la figure 5A, le courant de sortie du deuxième modèle FMU2 atteint 300 mA entre 50 et 120 ms (selon la température de l'environnement de l'organe de dosage de carburant), en considérant que le courant de consigne de 400 mA soit émis à partir de $t_0 = 0$ *ms.* En cas de court-circuit, la valeur de 300 mA est atteinte aux alentours de 30 ms comme cela est visible sur la figure 5B. Ainsi le temps de réponse est environ 15 fois supérieur au temps de réponse de la première configuration, comme dans le cas sans court-circuit.

Ainsi, qu'il y ait ou non un court-circuit, une mesure du courant à deux instants aux alentours de 2 ms, par exemple à des instants $t_1$ et $t_2$ compris entre 0 ms et 2 *ms,* permet de déduire la configuration matérielle de l'organe de dosage de carburant. En effet, si la valeur $I_1$ mesurée a une valeur comprise dans la gamme correspondant à la zone $Z_3$, valeurs pour lesquelles la configuration matérielle ne peut être déduite, mais que $I_2$ est compris dans la plage $[I_{min\ 2\ ;FMU1}; I_{max\ 2\ ;FMU1}]$ ou $[I_{min\ 2\ ;FMU2}; I_{max\ 2\ ;FMU2}]$, alors on peut tout de même en déduire que l'organe de dosage de carburant présente la même configuration matérielle soit que le premier modèle FMU1 soit que le deuxième modèle FMU2.

De préférence, le procédé est exécuté par l'unité de commande lors de la mise sous tension de l'équipement. En particulier, ce procédé est exécuté par chacun des calculateurs de protection de l'unité de commande.

Pour cela, les calculateurs de protection, comprenant un processeur couplé à une mémoire, contiennent en mémoire un programme d'ordinateur comprenant des instructions pour mettre en œuvre le procédé tel que décrit précédemment lorsqu'il est exécuté sur un processeur.

## Revendications

1. Procédé de détection d'une configuration matérielle d'un équipement embarqué dans un aéronef, apte à recevoir en entrée un courant de consigne *(Ic)*, et à produire en sortie un courant de réponse (*I*), le procédé comprenant les étapes :

   a) Envoyer en entrée de l'équipement un courant de consigne (*Ic* ) à un instant initial donné ($t_0$);

   **caractérisé par** les étapes suivantes :

   b) Mesurer une ou plusieurs valeurs de courant de réponse (*I*) en sortie de l'équipement dans un intervalle de temps de mesure défini entre deux instants ($t_1$, $t_2$) postérieurs à l'instant initial ($t_0$);
   c) Déduire la configuration matérielle de l'équipement, à partir desdites une ou plusieurs valeurs du courant de réponse (*I*) mesuré et des caractéristiques électriques de réponse en courant de l'équipement.

2. Procédé selon la revendication 1, dans lequel la configuration matérielle d'un équipement est au moins l'une des configurations suivantes :

   - un premier équipement ayant une première inductance $L_1$;
   - un deuxième équipement ayant une seconde inductance $L_2$;
   - un équipement de configuration matérielle inconnue,

   et dans lequel $L_2 = x \cdot L_1$ où $x \in \mathbb{R}$ et $x \geq 10$.

3. Procédé selon la revendication 2, dans lequel l'étape c) consiste à comparer les une ou plusieurs valeurs du courant de réponse (*I*) mesuré à un premier seuil ($I_{min1,FMU1}$) et à un second seuil ($I_{max2,FMU2}$) inférieur au premier seuil, de sorte que :

   - un premier équipement est détecté, si les valeurs du courant de réponse mesuré (*I*) *sont supérieures au premier seuil ( $I_{min1,FMU1}$)*,
   - un second équipement est détecté, si les valeurs du courant de réponse mesuré (*I*) *sont inférieures au second seuil($I_{max2,FMU2}$)*,
   - un équipement de configuration matérielle inconnue est détecté si les valeurs du courant mesuré *I sont comprises entre le second seuil et le premier seuil.*

4. Procédé selon la revendication 1 ou 2, comprenant en outre une étape consistant à :

   - mesurer une ou plusieurs valeurs du courant de réponse (*I*) à au moins un instant ($t_3$) postérieur à une valeur de borne supérieure ($t_2$) de l'intervalle de temps de mesure et
   - déduire que la configuration matérielle est celle d'un premier équipement défectueux ou celle d'un second équipement défectueux si les valeurs du courant de réponse mesuré *(1) sont inférieures à un troisième seuil ($I_{min3}$ ).*

5. Procédé selon l'une quelconque des revendications 2 à 4, dans lequel les configurations matérielles des premier et second équipements ont une même valeur de résistance.

6. Procédé selon la revendication 2 ou selon la revendication 3, dans lequel la première inductance $L_1$ est de l'ordre de 100 *mH* et la seconde inductance $L_2$ est de l'ordre de 1*H.*

7. Procédé selon l'une des revendications précédentes, dans lequel le courant de réponse (*I*) en sortie de l'équipement s'exprime :

$$I = Ic \left( 1 - e^{-\frac{t}{\sigma}} \right) avec \ \sigma = \frac{L}{R}$$

avec dans lequel, *L* est l'impédance de l'équipement et *R* est la résistance de l'équipement.

8. Procédé selon l'une des revendications précédentes, dans lequel le courant de consigne (*Ic*) est envoyé par un calculateur de protection embarqué de l'aéronef.

9. Procédé selon l'une des revendications précédentes, dans lequel les étapes a) à c) sont réalisées lors d'une mise sous tension de l'équipement.

10. Calculateur de protection comprenant un processeur couplé à une mémoire sur laquelle sont enregistrées des instructions pour mettre en œuvre le procédé selon l'une quelconque des revendications 1 à 8 lorsque exécuté sur le calculateur de protection.

## Claims

1. A method for detecting a hardware configuration of an on-board device in an aircraft, capable of receiving as input a setpoint current *(Ic),* and of producing as output a response current (*I*), the method comprising the following steps:

   a) Send, to the input of the device, a setpoint current (*Ic*) at a given initial time ($t_0$);

   caracterized by the following steps:

   b) Measure one or more response current values (*I*) at the output of the device in a measurement-time interval defined between two instants ($t_1$, $t_2$) after the initial instant ($t_0$);
   c) Infer the hardware configuration of the device, doing so from the one or more said values of the response current (*I*) measured and the electrical current-response characteristics of the device.

2. A method according to claim 1, wherein the hardware configuration of a device is at least one of the following configurations:

   - a first device having a first inductance $L_1$;
   - a second device having a second inductance $L_2$;
   - a device of unknown hardware configuration,

   and wherein $L_2 = x \cdot L_1$ où $x \in \mathbb{R}$ and $x \geq 10$.

3. A method according to claim 2, wherein step c) comprises comparing the one or more values of the response current (*I*) measured at a first threshold ($I_{min1,FMU1}$) and at a second threshold ($I_{max2,FMU2}$) lower than the first threshold, such that:

   - a first device is detected, if the values of the measured response current (*I*) *are higher than the first threshold* ($I_{min1,FMU1}$),
   - a second device is detected, if the values of the measured response current (*I*) *are lower than the second threshold*($I_{max2,FMU2}$) ,
   - a device of unknown hardware configuration is detected if the values of the measured current *I sare between the second threshold and the first threshold.*

4. A method according to claim 1 or 2, further comprising the following step:

   - measure one or more values of the response current *(I)* at at least one time ($t_3$) after an upper bound value ($t_2$) of the measurement time interval, and
   - infer that the hardware configuration is that of a first defective device or that of a second defective device if the values of the measured response current *(I) are lower than a third threshold ($I_{min\ 3}$ ).*

5. A method according to any of claims 2 to 4, wherein the hardware configurations of the first and second devices have a same resistance value.

6. A method according to claim 2 or claim 3, wherein the first inductance $L_1$ is of the order of 100 *mH* and the second inductance $L_2$ is of the order of 1*H.*

7. A method according to any of the preceding claims, wherein the response current (*I*) at the output of the device is expressed as:

$$I = Ic \left(1 - e^{-\frac{t}{\sigma}}\right) avec\ \sigma = \frac{L}{R}$$

   wherein, L is the impedance of the device and R is the resistance of the device.

8. A method according to any of the preceding claims, wherein the setpoint current *(Ic)* is sent by an on-board protection calculator of the aircraft.

9. A method according to any of the preceding claims, wherein steps a) to c) are performed when the device is powered up.

10. A protection calculator comprising a processor coupled to a memory on which are stored instructions for implementing the method of any one of claims 1 to 8 when executed on the protection calculator.

## Patentansprüche

1. Verfahren zur Erkennung einer Hardwarekonfiguration eines an Bord eines Luftfahrzeugs mitgeführten Geräts, das am Eingang einen Sollwertstrom (*Ic*) empfangen und am Ausgang einen Antwortstrom (*I*) erzeugen kann, wobei das Verfahren die folgenden Schritte umfasst:

   a) Senden eines Sollwertstroms (*Ic*) zu einem gegebenen Anfangszeitpunkt ($t_0$) an den Eingang des Geräts;

   **gekennzeichnet durch** die folgenden Schritte:

b) Messen eines oder mehrerer Werte des Antwortstroms ($I$) am Ausgang des Geräts in einem Messzeitintervall, das zwischen zwei Zeitpunkten ($t_1$, $t_2$) nach dem Anfangszeitpunkt ($t_0$) definiert ist;
c) Ableiten der Hardwarekonfiguration des Geräts aus dem einen oder den mehreren Werten des gemessenen Antwortstroms ($I$) und den elektrischen Eigenschaften der Stromantwort des Geräts.

2. Verfahren nach Anspruch 1,

   wobei es sich bei der Hardwarekonfiguration eines Geräts um zumindest eine der folgenden Konfigurationen handelt:

   - ein erstes Gerät mit einer ersten Induktivität $L_1$,
   - ein zweites Gerät mit einer zweiten Induktivität $L_2$;
   - ein Gerät mit unbekannter Hardwarekonfiguration,

   und wobei gilt: $L_2 = x \cdot L_1$ worin $x \in \mathbb{R}$ und $x \geq 10$.

3. Verfahren nach Anspruch 2,
   wobei Schritt c) darin besteht, den einen oder die mehreren Werte des gemessenen Antwortstroms ($I$) mit einem ersten Schwellenwert ($I_{min1,FMU1}$) und einem zweiten Schwellenwert ($I_{max2,FMU2}$), der niedriger als der erste Schwellenwert ist, zu vergleichen, so dass:

   - ein erstes Gerät erkannt wird, wenn die Werte des gemessenen Antwortstroms ($I$) den ersten Schwellenwert ($I_{min1,FMU1}$) überschreiten,
   - ein zweites Gerät erkannt wird, wenn die Werte des gemessenen Antwortstroms ($I$) den zweiten Schwellenwert ($I_{max2,FMU2}$) unterschreiten,
   - ein Gerät mit unbekannter Hardwarekonfiguration erkannt wird, wenn die Werte des gemessenen Stroms ($I$) zwischen dem zweiten Schwellenwert und dem ersten Schwellenwert liegen.

4. Verfahren nach Anspruch 1 oder 2, ferner umfassend den Schritt:

   - Messen eines oder mehrerer Werte des Antwortstroms ($I$) zu mindestens einem Zeitpunkt ($t_3$), der nach einem oberen Grenzwert ($t_2$) des Messzeitintervalls liegt, und
   - Ableiten, dass die Hardwarekonfiguration die eines ersten fehlerhaften Geräts oder die eines zweiten fehlerhaften Geräts ist, wenn die Werte des gemessenen Antwortstroms ($I$) einen dritten Schwellenwert ($I_{min3}$) unterschreiten.

5. Verfahren nach einem der Ansprüche 2 bis 4, wobei die Hardwarekonfigurationen des ersten und des zweiten Geräts denselben Widerstandswert aufweisen.

6. Verfahren nach Anspruch 2 oder nach Anspruch 3, wobei die erste Induktivität $L_1$ in der Größenordnung von 100 mH liegt und die zweite Induktivität $L_2$ in der Größenordnung von 1 H liegt.

7. Verfahren nach einem der vorhergehenden Ansprüche,

   wobei für den Antwortstrom ($I$) am Ausgang des Geräts gilt:

   $$I = Ic \left( 1 - e^{\frac{t}{\sigma}} \right) \text{ mit } \sigma = \frac{L}{R}$$

   wobei L die Impedanz des Geräts ist und R der Widerstand des Geräts ist.

8. Verfahren nach einem der vorhergehenden Ansprüche, wobei der Sollwertstrom ($Ic$) von einem an Bord des Luftfahrzeugs mitgeführten Sicherheitsrechner gesendet wird.

9. Verfahren nach einem der vorhergehenden Ansprüche, wobei die Schritte a) bis c) bei einem Einschalten des Geräts erfolgen.

10. Sicherheitsrechner mit einem Prozessor, der mit einem Speicher gekoppelt ist, in dem Anweisungen abgespeichert sind, um, bei Ausführung auf dem Sicherheitsrechner, das Verfahren nach einem der Ansprüche 1 bis 8 durchzuführen.

# Fig. 1

# Fig. 2

# Fig. 3

# Fig. 4A

# Fig. 4B

# Fig. 5A

# Fig. 5B

**RÉFÉRENCES CITÉES DANS LA DESCRIPTION**

**Documents brevets cités dans la description**

- US 2017356948 A
- US 2009052107 A
- US 5490031 A